# DEMANDE DE BREVET EUROPEEN

(11) **EP 2 484 628 A1**
(43) Date de publication de la demande: **08.08.2012**
(21) Numéro de dépôt: 11153243.8
(22) Date de dépôt: 03.02.2011
(51) Int. Cl.: B81C 99/00

(54) **Pièce de micromécanique à faible ruguosité de surface**

(71) Demandeur: Nivarox-FAR S.A., 2400 Le Locle (CH)
(72) Inventeur: Cusin, Pierre, 1423, Villars-Burquin (CH); Richard, David, 1400, Yverdon-les-Bains (CH); Dubois, Philippe, 2074, Marin (CH)
(74) Mandataire: Couillard, Yann Luc Raymond

(57) **Abrégé**

L'invention se rapporte à une pièce de micromécanique (11, 21, 31, 41, 51, 61) en un matériau monobloc. Selon l'invention, elle comporte une section élémentaire formée d'au moins deux segments sécants et non alignés afin qu'un desdits au moins deux segments forme la hauteur (e₃) de la pièce de micromécanique (11, 21, 31, 41, 51, 61), ladite hauteur étant supérieure à l'épaisseur (e₁) de chaque segment.

L'invention concerne également son procédé de fabrication

## Description

### Domaine de l'invention

L'invention se rapporte à une pièce de micromécanique complexe fabriquée à partir d'un matériau quelconque comme par exemple à base de carbone ainsi qu'à un procédé de fabrication d'une telle pièce.

### Arrière plan de l'invention

La fabrication de pièce de micromécanique uniquement en diamant synthétique ou en DLC (abréviation provenant des termes anglais « Diamond Like Carbon ») est très chère et n'est pas tribologiquement favorable à cause de la rugosité défavorable générée par le processus de dépôt en couche épaisse ou par un procédé de gravage dans la masse. Par conséquent, actuellement, on pratique plutôt le revêtement de pièce de micromécanique à l'aide de diamant synthétique ou de DLC en fine couche sans toutefois pouvoir obtenir n'importe quelle forme.

### Résumé de l'invention

Le but de la présente invention est de pallier tout ou partie les inconvénients cités précédemment en proposant une pièce de micromécanique de géométrie complexe utilisant une quantité minimale de matériau dont la rugosité est très améliorée permettant un taux et un coût de rebut très favorables.

A cet effet, l'invention se rapporte à une pièce de micromécanique en un matériau monobloc caractérisée en ce qu'elle comporte une section élémentaire formée d'au moins deux segments sécants et non alignés afin qu'un desdits au moins deux segments forme la hauteur de la pièce de micromécanique, ladite hauteur étant supérieure à l'épaisseur de chaque segment.

On comprend donc que la pièce de micromécanique monobloc, c'est-à-dire sans discontinuité de matière, est formée par une « peau » de matériau, c'est-à-dire peu de matériau, ce qui permet de diminuer très sensiblement le prix de la pièce et d'améliorer sa rugosité à des fins tribologiques.

Conformément à d'autres caractéristiques avantageuses de l'invention :
- la section comporte trois segments en forme sensiblement de U ;
- la pièce de micromécanique est formée par la projection selon une directrice rectiligne ou non rectiligne comme une projection en révolution de la section élémentaire ;
- un desdits au moins deux segments de la section élémentaire est utilisé pour former une denture ;
- le matériau est à base de carbone sous forme cristallisée ou amorphe ;
- le creux de la section élémentaire est rempli d'un deuxième matériau afin rigidifier et/ou décorer la pièce de micromécanique ;
- le deuxième matériau fait saillie dudit creux de la section élémentaire afin de former un élément fonctionnel supplémentaire à la pièce de micromécanique ;
- le deuxième matériau comporte un métal ou un alliage métallique.

De plus, l'invention se rapporte à une pièce d'horlogerie caractérisée en ce qu'elle comporte une pièce de micromécanique selon l'une des variantes précédentes.

Enfin, l'invention se rapporte à un procédé de fabrication d'une pièce de micromécanique en un matériau monobloc caractérisé en ce qu'il comporte les étapes suivantes :
a) former un substrat comportant l'empreinte négative de ladite pièce de micromécanique à fabriquer ;
b) recouvrir ladite empreinte négative du substrat d'une couche d'un matériau ;
c) retirer du substrat une épaisseur supérieure à celle de la couche déposée afin de laisser une épaisseur de ladite couche circonscrite dans ladite empreinte négative ;
d) retirer le substrat afin de laisser libre la pièce de micromécanique formée dans ladite empreinte négative.

On comprend donc que le procédé autorise la fabrication d'une pièce de micromécanique monobloc, c'est-à-dire sans discontinuité de matière, qui comporte une « peau » de matériau, c'est-à-dire peu de matériau, dont la surface externe reprend la rugosité très favorable du substrat ce qui permet de diminuer très sensiblement le coût du matériau voulu sur la couche externe et d'améliorer la rugosité globale, surtout au niveau de la surface externe, pour parfaire sa tribologie.

Conformément à d'autres caractéristiques avantageuses de l'invention :
- l'empreinte négative comporte une paroi formant une denture ;
- le matériau est à base de carbone sous forme cristallisée ou amorphe ;
- le procédé comporte, entre l'étape b) et l'étape c), l'étape e) : remplir l'empreinte revêtue du premier matériau avec un deuxième matériau afin qu'après les étapes c) et d), on obtienne une pièce de micromécanique en un premier matériau renforcé et/ou décoré par un deuxième matériau ;
- le procédé comporte, entre l'étape c) et l'étape d), l'étape f) : remplir l'empreinte revêtue du premier matériau avec un deuxième matériau afin qu'après l'étape d), on obtienne une pièce de micromécanique en un premier matériau renforcé et/ou décoré par un deuxième matériau ;
- lors de l'étape f), le deuxième matériau est formé en saillie de ladite empreinte afin de former un élément fonctionnel supplémentaire à la pièce de micromécanique ;
- le deuxième matériau comporte un métal ou un alliage métallique.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 5 sont des représentations d'étapes successives d'un procédé de fabrication selon un premier mode de réalisation de l'invention ;
- les figures 6 à 10 sont des représentations d'exemples de pièces de micromécaniques obtenues selon un premier mode de réalisation de l'invention ;
- les figures 11 à 13 sont des représentations d'étapes successives d'un procédé de fabrication selon un deuxième mode de réalisation de l'invention ;
- la figure 14 est une représentation d'un exemple de pièce de micromécanique obtenue selon un deuxième mode de réalisation de l'invention ;
- les figures 15 et 16 sont des représentations d'étapes successives d'un procédé de fabrication selon un troisième mode de réalisation de l'invention ;
- la figure 17 est une représentation d'un exemple de pièce de micromécanique obtenue selon un troisième mode de réalisation de l'invention.

### Description détaillée des modes de réalisation préférés

Comme expliqué ci-dessus, l'invention se rapporte d'abord à une pièce de micromécanique monobloc par exemple en un matériau à base de carbone. A base de carbone signifie un allotrope synthétique du carbone sous forme cristalline, comme du diamant ou une ou plusieurs couches de graphène, ou sous forme amorphe, comme du DLC (abréviation provenant des termes anglais « Diamond Like Carbon »).

Bien entendu, avantageusement selon l'invention, d'autres types de matériaux, qui sont déposables sous forme de couche et qui présentent un intérêt tribologique, peuvent être utilisés alternativement à un allotrope synthétique du carbone. Un tel matériau alternatif peut, par exemple, être un composé à base de silicium, c'est-à-dire par exemple du nitrure de silicium, de l'oxyde de silicium ou du carbure de silicium.

Cette pièce de micromécanique a été imaginée pour des applications dans le domaine horloger. Toutefois, d'autres domaines peuvent parfaitement être imaginés comme notamment l'aéronautique, la bijouterie ou l'automobile.

Dans le domaine horloger, cette pièce de micromécanique peut, à titre d'exemple, former une partie de l'habillage, le spiral, le balancier, l'ancre, les ponts ou même les mobiles comme les roues d'échappement totalement ou partiellement à base d'un allotrope synthétique du carbone ou d'un matériau alternatif comme expliqué ci-dessus.

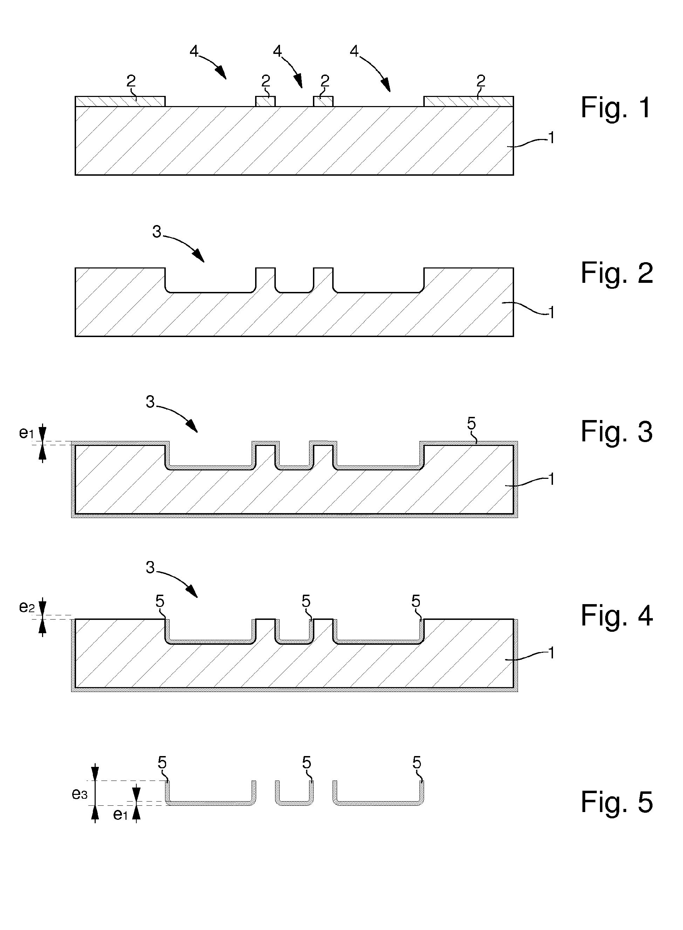

Un premier mode de réalisation d'un procédé de fabrication d'une telle pièce de micromécanique est présenté aux figures 1 à 5. Dans une étape a, le procédé consiste à former, dans un substrat 1, une empreinte 3 négative de la future pièce de micromécanique 11, 21, 31, 41. Une grande variété de substrats 1 est possible. Préférentiellement, la matière du substrat 1 est choisie pour sa très faible rugosité, c'est-à-dire son caractère naturel à présenter une surface lisse.

A titre d'exemple, les figures 1 et 2 présentent l'étape a formée à partir d'un substrat 1 en silicium pour lequel il est possible d'obtenir une très bonne rugosité, c'est-à-dire un écart moyen arithmétique Rₐ sensiblement inférieur à 10 nm. Ainsi, dans une première phase illustrée à la figure 1, le substrat 1 est revêtu d'un masque 2 présentant des ajourages 4 laissant non recouverte une partie supérieure du substrat 1. Dans une deuxième phase, un gravage selon les ajourages 4 est effectué. Un tel gravage peut être réalisé par une attaque sèche ou humide. Enfin, dans une troisième phase illustrée à la figure 2, le masque 2 est retiré pour ne laisser que l'empreinte 3 négative réalisée dans le substrat 1.

Une deuxième étape b consiste à recouvrir au moins l'empreinte négative 3 par une couche 5 d'épaisseur e₁ du matériau souhaité pour la future pièce de micromécanique. Dans l'exemple illustré à la figure 3, le substrat 1 est entièrement revêtue d'une couche 5, c'est-à-dire au moins dans l'empreinte 3 gravée lors de l'étape a. Comme pour le matériau déposé, le type de dépôt peut être très varié. A titre non limitatif, l'étape b peut comporter un dépôt chimique en phase vapeur, un dépôt physique en phase vapeur ou un dépôt par galvanoplastie.

Dans une troisième étape c, le procédé consiste à retirer une partie du substrat 1 revêtu de la couche 5 afin de laisser une épaisseur de ladite couche 5 circonscrite dans ladite empreinte négative 3. Préférentiellement selon l'invention, on enlève une épaisseur e₂ du substrat 1 supérieure à celle e₁ de la couche 5 comme illustré à la figure 4. On comprend donc que la couche 5 présente dans l'empreinte 3 du substrat 1 est désormais indépendante, c'est-à-dire non jointive, par rapport au reste de la couche 5 déposée lors de l'étape b.

Dans une quatrième et dernière étape d du premier mode de réalisation, le procédé consiste à retirer le substrat 1 afin de libérer la pièce de micromécanique formée dans l'empreinte 3. Par conséquent, dans l'exemple ci-dessus dans lequel le substrat 1 est en silicium, l'étape d peut consister en une attaque sélective du silicium. Cela peut, par exemple, être obtenu par une attaque chimique au moyen d'un bain comportant de l'hydroxyde de tétraméthylammonium (connu sous les abréviations TMAH et TMAOH).

A la fin de l'étape d, comme illustré à la figure 5, on obtient une pièce de micromécanique formée exclusivement par la couche 5 de géométrie correspondante à l'empreinte 3 présente dans le substrat 1. Avantageusement, la surface externe, c'est-à-dire la surface qui était directement en contact avec le substrat 1, comporte une très bonne rugosité, c'est-à-dire comparable à celle du substrat 1, et est, préférentiellement, utilisée comme surface de contact mécanique. Enfin, pour une hauteur e₃ de la pièce de micromécanique comprise entre 10 µm et 500 µm, seule une épaisseur e₁ de la couche 5 comprise entre 0,2 µm et 20 µm est déposée. On comprend donc immédiatement le gain en coût de matière et en coût de production dû au temps raccourci de l'étape b de dépôt.

Par conséquent, on comprend que l'on peut obtenir une pièce de micromécanique dont la section élémentaire est formée par au moins deux segments sécants et non alignés afin qu'un desdits au moins deux segments forme la hauteur e₃ de la pièce de micromécanique, ladite hauteur e₃ étant supérieure à l'épaisseur e₁ de chaque segment. Bien entendu suivant la complexité de l'empreinte 3, la section élémentaire peut être une section plus simple sensiblement en U, c'est-à-dire comportant trois segments.

Ainsi, suivant la complexité de l'empreinte 3, la pièce de micromécanique est formée par la projection selon une directrice rectiligne ou non (comprenant la révolution) d'au moins une section élémentaire à deux ou trois segments. De plus, il n'est pas plus difficile de former des sections très complexes ou variables comme, par exemple, former une denture sur une paroi de l'empreinte 3 qui formera une denture correspondante pour un des segments de la section.

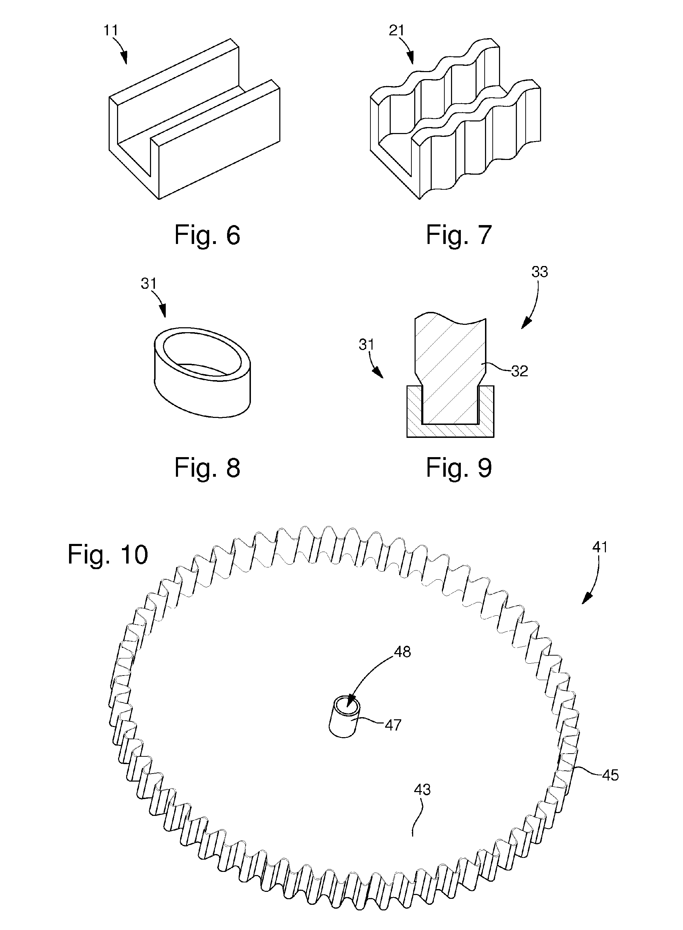

A titre d'exemples nullement limitatifs, des pièces de micromécanique 11, 21, 31, 41 susceptibles d'être obtenues selon le premier mode de réalisation sont présentées aux figures 6 à 10. Ainsi, la figure 6 présente une pièce de micromécanique 11 dont la section élémentaire sensiblement en U est projetée selon une directrice rectiligne. La figure 7 présente une pièce de micromécanique 21 de section élémentaire analogue à celle de la pièce de micromécanique 11 mais qui est projetée selon une directrice sinusoïdale, c'est-à-dire non-rectiligne. On comprend également qu'il est possible de former une pièce de micromécanique qui résulterait d'une moitié de la pièce 11 et de l'autre moitié de la pièce 21 aussi bien transversalement que longitudinalement en une seule pièce sans que le procédé en soit complexifié.

Les figures 8 et 9 présentent un exemple de section élémentaire pouvant être à deux segments qui est projetée en révolution pour obtenir une pièce de micromécanique 31 du type capuchon. Une telle pièce de micromécanique pourrait par exemple être solidarisée sur un élément afin d'améliorer sa tribologie avec un autre organe. A titre d'exemple, la pièce de micromécanique 31 peut être solidarisée à l'extrémité d'un pivot 32 d'un axe 33 afin que le pivot 32 coopère avec un coussinet par l'intermédiaire de la pièce de micromécanique 31.

Enfin, la figure 10 présente un dernier exemple d'une pièce de micromécanique 41 plus complexe sans que le procédé soit plus difficile à mettre en oeuvre. La pièce de micromécanique 41 comporte une planche 43 sensiblement discoïdale à partir de la périphérie de laquelle se projette orthogonalement une denture 45 et dont le centre comporte un canon 47 formant un trou 48 autorisant la coopération par exemple avec un axe de pivotement. A la figure 10, on s'aperçoit donc que l'épaisseur de la denture 45 et du canon 47 sont formées par l'épaisseur e₁ de la couche 5 déposée lors de l'étape b du procédé.

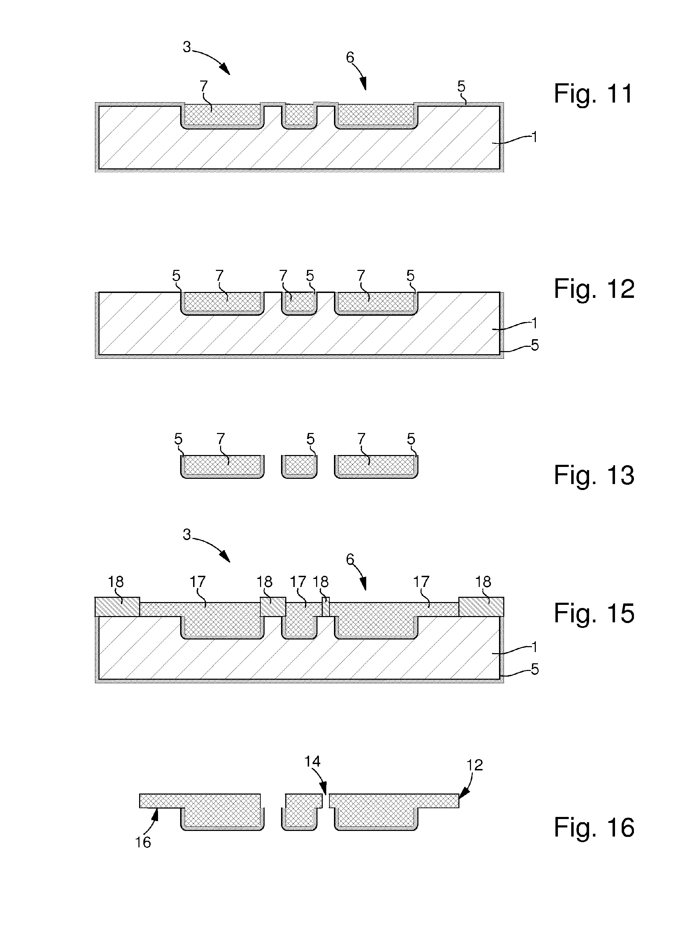

Un deuxième mode de réalisation alternatif au premier expliqué ci-dessus est présenté aux figures 11 à 13. Les étapes a à d restent identiques au premier mode de réalisation. Toutefois, comme illustré à la figure 11, une étape e est réalisée entre l'étape b et l'étape c qui consiste à remplir le creux 6 de l'empreinte 3, revêtue du premier matériau 5, avec un deuxième matériau 7. Ainsi, après les étapes c et d similaires au premier mode de réalisation et illustrées respectivement aux figures 12 et 13, on obtient une pièce de micromécanique en un premier matériau 5 renforcé et/ou décoré par un deuxième matériau 7.

Préférentiellement, le remplissage des creux 6 est effectué par un dépôt galvanique ou une déformation à chaud. Le deuxième matériau est, de manière préférée, un métal ou un alliage métallique qui peut être ou non amorphe. Toutefois, rien n'empêche alternativement de changer le type de dépôt et/ou la nature du matériau déposé.

Par conséquent, lors de la quatrième étape c, non seulement l'épaisseur de ladite couche 5 est circonscrite dans ladite empreinte négative 3 mais le dépôt 7 du deuxième matériau est rendu plan et préférentiellement affleurant à ladite partie circonscrite de la couche 5. Enfin, dans une cinquième et dernière étape d du deuxième mode de réalisation, le procédé consiste à retirer le substrat 1 afin de laisser libre la pièce de micromécanique formée dans l'empreinte 3 avec les mêmes avantages que pour le premier mode de réalisation.

A la fin de l'étape d, comme illustré à la figure 13, on obtient une pièce de micromécanique formée par la couche 5 de géométrie correspondante à l'empreinte 3 présente dans le substrat 1, laquelle est renforcée et/ou décorée avec le dépôt 7. Avantageusement, la surface externe formée par la couche 5, c'est-à-dire la surface qui était directement en contact avec le substrat 1, comporte une très bonne rugosité, c'est-à-dire comparable à celle du substrat 1 et est, préférentiellement, utilisée comme surface de contact.

Selon un autre avantage de l'invention, il est désormais possible de recouvrir des pièces avec des couches minces qu'il n'était pas possible de fabriquer auparavant à cause des conditions particulières de dépôt de la couche mince comme, par exemple, la pression, la température ou les composés utilisés. A titre non limitatif, de manière avantageuse selon l'invention, il est ainsi possible de former une pièce principalement métallique à partir du dépôt 7 qui est revêtue d'une couche de diamant à partir de la couche 5 alors qu'actuellement, il reste difficile à la connaissance de la Demanderesse de revêtir une pièce métallique avec du diamant.

Enfin, pour une hauteur e₃ de la pièce de micromécanique comprise entre 10 µm et 500 µm, seule une épaisseur e₁ de la couche 5 comprise entre 0,2 µm et 20 µm est déposée, le reste étant comblé par le dépôt 7. On comprend donc immédiatement le gain en coût de matière et en coût de production dû au temps raccourci de l'étape b de dépôt de la couche 5, le reste de la pièce étant formé par un dépôt 7 moins coûteux.

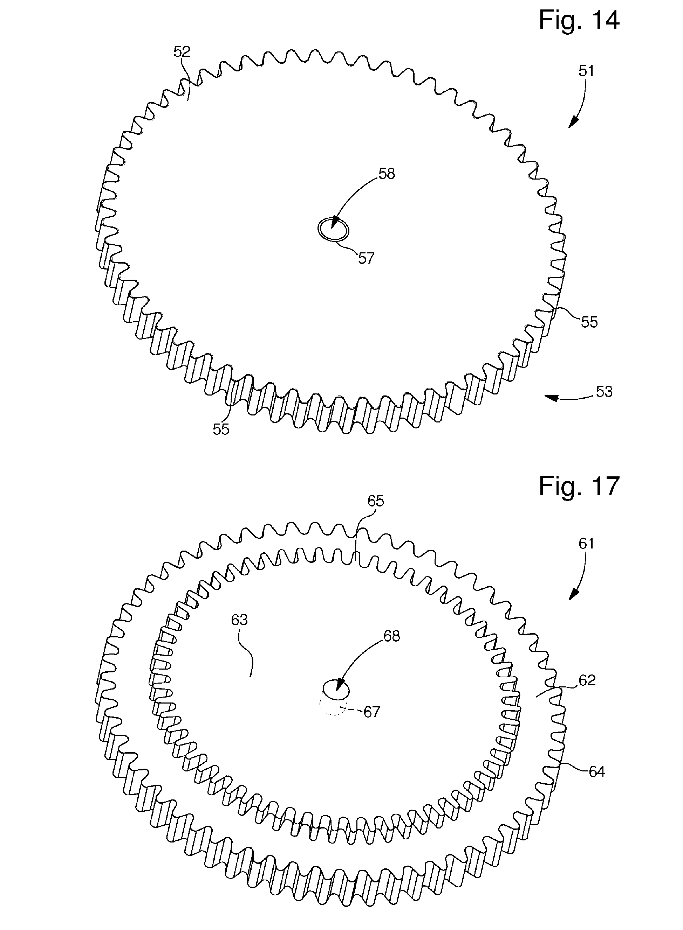

Par conséquent, on comprend que l'on peut obtenir une pièce de micromécanique selon les mêmes sections élémentaires que le premier mode de réalisation. A titre d'exemple nullement limitatif, une pièce de micromécanique 51 susceptible d'être obtenue selon le deuxième mode de réalisation est présentée à la figure 14. La pièce de micromécanique 51 comporte une planche 53 sensiblement discoïdale, comparable à celle 43 de la figure 10, à partir de la périphérie de laquelle se projette orthogonalement une denture 55 et dont le centre comporte un canon 57 formant un trou 58 autorisant la coopération par exemple avec un axe de pivotement. A la figure 14, on s'aperçoit donc que l'épaisseur de la denture 55 et du canon 57 sont formées par l'épaisseur e₁ de la couche 5 déposée lors de l'étape b du procédé, le reste étant comblé par la partie 52 formée par le dépôt 7 de l'étape e.

Un troisième mode de réalisation alternatif au premier expliqué ci-dessus est présenté aux figures 15 et 16. Les étapes a à d restent identiques au premier mode de réalisation. Toutefois, comme illustré à la figure 15, une quatrième étape f est réalisée entre l'étape c et l'étape d qui consiste à remplir le creux 6 de l'empreinte 3, revêtue du premier matériau 5, avec un deuxième matériau 17. Ainsi, après l'étape d similaire au premier mode de réalisation et illustrée à la figure 16, on obtient une pièce de micromécanique en un premier matériau 5 renforcé et/ou décoré par un deuxième matériau 7.

En comparaison de l'étape e du deuxième mode de réalisation, l'étape f est destinée à remplir le creux 6 de l'empreinte 3 et, avantageusement, permet également de former un niveau en saillie de l'épaisseur e₃ afin de former un élément fonctionnel supplémentaire à la pièce de micromécanique comme illustré à la figure 15.

L'étape f comporte de manière préférée une phase de structuration d'un moule 18 sur le substrat 1 après l'étape c. Puis une phase de remplissage de l'évidement formé conjointement par le creux 6 de l'empreinte 3 et les ajourages du moule 18. Enfin, l'étape f comporte une phase de retrait du moule 18 de la surface du substrat 1.

La phase de structuration du moule 18 peut, à titre d'exemple, être formée à l'aide d'une photolithographie d'une résine photosensible du type négatif ou positif. De plus, la phase de remplissage peut, à titre d'exemple, être réalisée à l'aide d'une galvanoplastie. Le deuxième matériau est, de manière préférée, un métal ou un alliage métallique qui peut être ou non amorphe. Toutefois, rien n'empêche alternativement de changer le type de dépôt et/ou la nature du matériau déposé.

L'étape f peut également comporter une ultime phase de rodage et/ou de polissage de la partie supérieure du dépôt 17. Par conséquent, dans une cinquième et dernière étape d du troisième mode de réalisation, le procédé consiste à retirer le substrat 1 afin de laisser libre la pièce de micromécanique formée dans l'empreinte 3 avec les mêmes avantages que pour le premier mode de réalisation.

A la fin de l'étape d, comme illustré à la figure 16, on obtient une pièce de micromécanique formée par la couche 5 de géométrie correspondante à l'empreinte 3 présente dans le substrat 1, laquelle est renforcée et/ou décorée avec le dépôt 17. Avantageusement, la surface externe inférieure est formée par la couche 5, c'est-à-dire la surface qui était directement en contact avec le substrat 1, comporte une très bonne rugosité, c'est-à-dire comparable à celle du substrat 1 et est, préférentiellement, utilisée comme surface de contact.

Selon un autre avantage de l'invention, il est désormais possible de recouvrir des pièces avec des couches minces qu'il n'était pas possible de fabriquer auparavant à cause des conditions particulières de dépôt de la couche mince comme, par exemple, la pression, la température ou les composés utilisés. A titre non limitatif, de manière avantageuse selon l'invention, il est ainsi possible de former une pièce principalement métallique à partir du dépôt 17 qui est partiellement revêtue d'une couche de diamant à partir de la couche 5 alors qu'actuellement, il reste difficile à la connaissance de la Demanderesse de revêtir une pièce métallique avec du diamant.

De plus, dans le troisième mode de réalisation, la pièce de micromécanique comporte également un deuxième niveau supérieur entièrement formé par le dépôt 17, c'est-à-dire sans couche 5, afin de former un élément fonctionnel supplémentaire à la pièce de micromécanique. Cet élément fonctionnel peut, à titre non limitatif, être une denture 12, un trou 14 et/ou une portée 16 destinés, par exemple, à coopérer avec un autre organe.

Comme pour les deux premiers modes de réalisation, on comprend donc immédiatement le gain en coût de matière et en coût de production dû au temps raccourci de l'étape de dépôt de la couche 5, le reste de la pièce étant formé par un dépôt 17 moins coûteux tout en offrant une géométrie qui peut être très complexe.

Par conséquent, on comprend que l'on peut obtenir une pièce de micromécanique selon les mêmes sections élémentaires que les deux premiers modes de réalisation. A titre d'exemple nullement limitatif, une pièce de micromécanique 61 susceptible d'être obtenue selon le troisième mode de réalisation est présentée à la figure 17. La pièce de micromécanique 61 comporte une planche 63 sensiblement discoïdale, comparable à celle 43 de la figure 10, à partir de la périphérie de laquelle se projette orthogonalement une denture 65 et dont le centre comporte un canon 67 formant un trou 68, le reste étant comblé par le dépôt 17 lors de l'étape f. Sur un second niveau uniquement formé par le dépôt 17, la pièce de micromécanique 61 comporte une roue 62 dont la périphérie comporte une denture 64 et dont le centre comporte un trou de section préférentiellement plus faible que le trou 68 destiné, par exemple, à coopérer avec un axe de pivotement.

Bien entendu, la présente invention ne se limite pas à l'exemple illustré mais est susceptible de diverses variantes et modifications qui apparaîtront à l'homme de l'art. En particulier, plusieurs pièces de micromécanique de motif identique ou non peuvent être fabriquées en même temps sur un même substrat. De plus, dans l'exemple de la figure 4 ou de la figure 12, on s'aperçoit que le retrait du substrat 1 forme également une pièce de section sensiblement en U formée par la couche 5 sur la périphérie et la partie inférieure du substrat 1.

Par conséquent, non seulement plusieurs empreintes 3 identiques ou non peuvent être formées sur le substrat 1 mais elles peuvent l'être également sur plusieurs faces du substrat 1, c'est-à-dire que les étapes a et c, et, éventuellement, e ou f, peuvent être appliquées à plusieurs faces du substrat 1. Dans le cas des deuxième et troisième modes de réalisation, il est ainsi envisageable d'obtenir une pièce monobloc formée par la couche 5 sur la périphérie et/ou la partie inférieure du substrat 1 et une pièce renforcée et/ou décorée formée par la couche 5 et le dépôt 7, 17 sur la partie supérieure du substrat 1.

De plus, les modes de réalisation sont combinables entre eux. Ainsi à titre d'exemple non limitatif, la pièce 51 peut être obtenue à l'aide du troisième mode de réalisation modifié. En effet, les étapes a à c pourraient être mise en oeuvre suivi d'une étape f dont le dépôt 17 serait similaire au dépôt 7 du deuxième mode de réalisation, c'est-à-dire ne faisant pas saillie de l'empreinte 3. On comprend donc que l'étape f modifiée du troisième mode de réalisation serait similaire à l'étape e du deuxième mode de réalisation mais en étant effectuée après l'étape c et non après l'étape b.

Enfin, même si les segments sont présentés sensiblement perpendiculaires sur les figures, il est bien évident que l'angle qu'ils forment l'un par rapport à l'autre peut également être aigu ou obtus.

## Revendications

1. Pièce de micromécanique (11, 21, 31, 41, 51, 61) en un matériau monobloc **caractérisée en ce qu'**elle comporte une section élémentaire formée d'au moins deux segments sécants et non alignés afin qu'un desdits au moins deux segments forme la hauteur (e₃) de la pièce de micromécanique (11, 21, 31, 41, 51, 61), ladite hauteur étant supérieure à l'épaisseur (e₁) de chaque segment.

2. Pièce de micromécanique (11, 21, 31, 41, 51, 61) selon la revendication précédente, **caractérisée en ce que** la section comporte trois segments en forme sensiblement de U.

3. Pièce de micromécanique (11, 21, 31, 41, 51, 61) selon la revendication 1 ou 2, **caractérisée en ce que** la pièce de micromécanique est formée par la projection selon une directrice rectiligne de la section élémentaire.

4. Pièce de micromécanique (11, 21, 31, 41, 51, 61) selon la revendication 1 ou 2, **caractérisée en ce que** la pièce de micromécanique est formée par la projection selon une directrice non rectiligne de la section élémentaire.

5. Pièce de micromécanique (11, 21, 31, 41, 51, 61) selon la revendication précédente, **caractérisée en ce que** la pièce de micromécanique est formée par la projection en révolution de la section élémentaire.

6. Pièce de micromécanique (21, 41, 51, 61) selon l'une des revendications précédentes, **caractérisée en ce qu'**un desdits au moins deux segments de la section élémentaire est utilisé pour former une denture (45, 55, 65).

7. Pièce de micromécanique (11, 21, 31, 41, 51, 61) selon l'une des revendications précédentes, **caractérisée en ce que** le matériau (5) est à base de carbone sous forme cristallisée.

8. Pièce de micromécanique (11, 21, 31, 41, 51, 61) selon l'une des revendications 1 à 6, **caractérisée en ce que** le matériau (5) est à base de carbone sous forme amorphe.

9. Pièce de micromécanique (51, 61) selon l'une des revendications précédentes, **caractérisée en ce que** le creux (6) de la section élémentaire est rempli d'un deuxième matériau (7, 17) afin rigidifier et/ou décorer la pièce de micromécanique (51, 61).

10. Pièce de micromécanique (61) selon la revendication précédente, **caractérisée en ce que** le deuxième matériau (17) fait saillie dudit creux de la section élémentaire afin de former un élément fonctionnel (12, 14, 16, 62) supplémentaire à la pièce de micromécanique.

11. Pièce de micromécanique (51, 61) selon la revendication 9 ou 10, **caractérisée en ce que** le deuxième matériau (7, 17) comporte un métal ou un alliage métallique.

12. Pièce d'horlogerie **caractérisée en ce qu'**elle comporte une pièce de micromécanique (11, 21, 31, 41, 51, 61) selon l'une des revendications précédentes.

13. Procédé de fabrication d'une pièce de micromécanique (11, 21, 31, 41, 51, 61) en un matériau monobloc **caractérisé en ce qu'**il comporte les étapes suivantes :
a) former un substrat (1) comportant l'empreinte (3) négative de ladite pièce de micromécanique à fabriquer ;
b) recouvrir ladite empreinte négative du substrat (1) d'une couche (5) d'un matériau ;
c) retirer du substrat (1) une épaisseur supérieure (e₂) à celle (e₁) de la couche déposée (5) afin de laisser une épaisseur de ladite couche circonscrite dans ladite empreinte négative ;
d) retirer le substrat (1) afin de laisser libre la pièce de micromécanique (11, 21, 31, 41, 51, 61) formée dans ladite empreinte négative.

14. Procédé selon la revendication 13, **caractérisé en ce que** l'empreinte (3) négative comporte une paroi formant une denture (45, 55, 65).

15. Procédé selon la revendication 13 ou 14, **caractérisée en ce que** le matériau (5) est à base de carbone sous forme cristallisée.

16. Procédé selon la revendication 13 ou 14, **caractérisée en ce que** le matériau (5) est à base de carbone sous forme amorphe.

17. Procédé selon l'une des revendications 13 à 16, **caractérisé en ce qu'**il comporte, entre l'étape b) et l'étape c), l'étape suivante :
e) remplir l'empreinte (3) revêtue du premier matériau (5) avec un deuxième matériau (7) afin qu'après les étapes c) et d), on obtienne une pièce de micromécanique (51) en un premier matériau (5) renforcé et/ou décoré par un deuxième matériau (7).

18. Procédé selon l'une des revendications 13 à 16, **caractérisé en ce qu'**il comporte, entre l'étape c) et l'étape d), l'étape suivante :
f) remplir l'empreinte (3) revêtue du premier matériau (5) avec un deuxième matériau (7, 17) afin qu'après l'étape d), on obtienne une pièce de micromécanique (51, 61) en un premier matériau (5) renforcé et/ou décoré par un deuxième matériau (7, 17).

19. Procédé selon la revendication précédente, **caractérisé en ce que**, lors de l'étape f), le deuxième matériau (17) est formé en saillie de ladite empreinte afin de former un élément fonctionnel (12, 14, 16, 62) supplémentaire à la pièce de micromécanique.

20. Procédé selon l'une des revendications 17 à 19, **caractérisé en ce que** le deuxième matériau (7, 17) comporte un métal ou un alliage métallique.
